# EUROPÄISCHE PATENTSCHRIFT

(11) **EP 3 251 472 B1**
(45) Veröffentlichungstag und Bekanntmachung des Hinweises auf die Patenterteilung: **18.08.2021**
(21) Anmeldenummer: 15820042.8
(22) Anmeldetag: 18.12.2015
(51) Int. Cl.: H05K 1/02, H05K 7/14

(54) **ELEKTROGERÄT, BAUREIHE VON ELEKTROGERÄTEN UND VERFAHREN ZUR HERSTELLUNG**
ELECTRICAL DEVICE, SERIES OF ELECTRICAL DEVICES AND METHOD FOR PRODUCING SAME
APPAREIL ÉLECTRIQUE, SÉRIE D'APPAREILS ÉLECTRIQUES ET PROCÉDÉ DE FABRICATION

(30) Priorität: 28.01.2015 DE 102015000939
(43) Veröffentlichungstag der Anmeldung: 06.12.2017
(73) Patentinhaber: SEW-EURODRIVE GmbH & Co. KG, 76646 Bruchsal (DE)
(72) Erfinder: KOLBERT, Alexander, 76356 Weingarten (DE); MOMANN, Dirk, 76646 Bruchsal (DE)
(86) Internationale Anmeldenummer: PCT/EP2015/002560
(87) Internationale Veröffentlichungsnummer: WO 2016/119808

(56) Entgegenhaltungen:
- DE-A1- 10 224 168
- DE-A1-102006 032 441
- DE-A1-102011 056 396
- None

## Beschreibung

Die Erfindung betrifft ein Elektrogerät, eine Baureihe von Elektrogeräten und ein Verfahren zur Herstellung.

Aus der DE 10 2005 054 601 A1 ist ein Elektrogerät mit Steckverbindern bekannt.

**Die** DE 10 2011 056 396 A1 **zeigt eine elektrische Motorbaugruppe und eine elektrische Servolenk-Vorrichtung.**

**In der** DE 102 24 168 A1 **ist eine Schaltungsanordnung zur Steuerung elektromotorischer Antriebsmittel eines fahrbaren Arbeitsgerätes, insbesondere eines Flurförderzeugs gezeigt.**

**Aus der** DE 10 2006 032 441 A1 **sind eine Vorrichtung aufweisend eine Leiterplatte und ein Modul sowie Verfahren zum Aufbau einer derartigen Vorrichtung bekannt.**

**Keines dieser Dokumente offenbart jedoch, dass ein zweites Steckverbinderteil auf einer weiteren Leiterplatte bestückt ist und mittels Leiterbahnen mit Verbindungsmitteln elektrisch leitend verbunden ist, wobei die Durchkontaktierungen auf einer ersten Leiterplatte jeweils mittels eines Kabels elektrisch leitend mit den Verbindungsmitteln verbunden sind.**

Der Erfindung liegt daher die Aufgabe zugrunde, ein Elektrogerät, eine Baureihe von Elektrogeräten und ein Verfahren zur Herstellung weiterzubilden, wobei der Umweltschutz verbessert werden soll.

Erfindungsgemäß wird die Aufgabe bei dem Elektrogerät nach den in Anspruch 1 angegebenen Merkmalen, bei der Baureihe von Elektrogeräten nach den in Anspruch 11 angegebenen Merkmalen und bei dem Verfahren zur Herstellung nach den in Anspruch 12, angegebenen Merkmalen gelöst.

Wichtige Merkmale der Erfindung bei dem Elektrogerät, aufweisend eine Leiterplatte mit Leiterbahnen,
wobei die Leiterplatte zwei gleichartige und/oder identische Kontaktflächenanordnungen aufweist,
wobei eine erste der Kontaktflächenanordnungen mit einem ersten Leistungsmodul bestückt ist und eine zweite Kontaktflächenanordnung mit einem zweiten Leistungsmodul bestückt ist,
wobei das Elektrogerät
- eine weitere Leiterplatte, aufweisend weitere Leiterbahnen und Verbindungsmittel,
- und ein zweites Steckverbinderteil aufweist,
wobei das zweite Leistungsmodul mittels Kontaktflächen der zweiten Kontaktflächenanordnung und der Leiterbahnen mit Durchkontaktierungen elektrisch leitend verbunden ist,
**wobei das zweite Steckverbinderteil auf der weiteren Leiterplatte** bestückt ist und mittels der weiteren Leiterbahnen mit den Verbindungsmitteln elektrisch leitend verbunden ist,
wobei die Durchkontaktierungen jeweils mittels eines Kabels elektrisch leitend mit den Verbindungsmitteln verbunden sind.

Von Vorteil ist dabei, dass Elektrogeräte zur Speisung von einem oder zwei Elektromotoren mit identischer Leiterplatte herstellbar sind. Jeder Elektromotor ist unabhängig von dem jeweils anderen Elektromotor aus dem entsprechenden Leistungsmodul speisbar.

Vorteilhafterweise sind zwei Elektromotoren mit unterschiedlicher Leistung speisbar, indem zwei Leistungsmodule mit verschiedener Leistung bestückbar sind.

Zwei identische Leiterplatten sind für ein Elektrogerät zur Speisung von zwei Elektromotoren und für ein Elektrogerät zur Speisung von einem Elektromotor verwendbar. Es ist ein Baukasten von Elektrogeräten mit einer in verschiedenen Varianten verwendbaren Komponente ausführbar. Die Lagerhaltung von verschiedenen Komponenten ist reduzierbar und der Umweltschutz ist verbessert.

Bei einer vorteilhaften Ausgestaltung ist aus dem jeweiligen Leistungsmodul ein jeweiliger Elektromotor speisbar. Von Vorteil ist dabei, dass das die Elektromotoren unabhängig voneinander steuerbar sind.

Die Leiterplatte weist eine Durchkontaktierung auf, wobei die Durchkontaktierung mittels Leiterbahnen auf der Leiterplatte elektrisch leitend mit einer Kontaktfläche der zweiten Kontaktflächenanordnung verbunden ist. Von Vorteil ist dabei, dass die Durchkontaktierung mit einem Kabel elektrisch leitend verbunden ist. Vorteilhafterweise ist ein Endbereich des Kabels in einfacher Art und Weise in die Durchkontaktierung einführbar und mit der Durchkontaktierung lötverbindbar. Somit sind Leiterbahnen auf der Leiterplatte einsparbar. Vorteilhafterweise ist die Zahl der unbestückten Bestückungsplätze und blind endenden Leiterbahnen auf der Leiterplatte mit nur dem ersten Leistungsmodul reduzierbar.

Bei einer vorteilhaften Ausgestaltung sind auf der Leiterplatte elektrische Bauteile bestückt, wobei die zweite Kontaktflächenanordnung elektrisch isoliert von allen diesen elektrischen Bauteilen angeordnet ist. Von Vorteil ist dabei, dass das auf der zweiten Kontaktflächenanordnung bestückbare zweite Leistungsmodul unabhängig von dem ersten Leistungsmodul steuerbar ist.

Bei einer Ausgestaltung, die nicht zur Erfindung gehört, ist das zweite Leistungsmodul nicht bestückt. Von Vorteil ist dabei, dass eine identische Leiterplatte für Elektrogeräte mit einem Leistungsmodul oder für Elektrogeräte mit zwei Leistungsmodulen verwendbar ist. Es ist ein Baukasten von Elektrogeräten mit einer in verschiedenen Varianten verwendbaren Komponente ausführbar. Die Lagerhaltung von verschiedenen Komponenten ist reduzierbar und der Umweltschutz ist verbessert.

Bei einer vorteilhaften Ausgestaltung weist die Leiterplatte einen Bestückungsplatz auf, der zur elektrischen Kontaktierung eines zu einem ersten elektrischen Bauteil, insbesondere der elektrischen Bauteile, gleichartigen elektrischen Bauteiles geeignet ist, wobei der Bestückungsplatz beabstandet und/oder elektrisch isoliert angeordnet ist von dem ersten elektrischen Bauteil. Von Vorteil ist dabei, dass weitere elektrische Bauteile zur Steuerung und/oder Versorgung des zweiten Leistungsmoduls auf der Leiterplatte bestückbar sind. Vorteilhafterweise sind diese weiteren Bauteile bei dem Elektrogerät zur Speisung von einem Elektromotor nicht bestückt. Diese weiteren Bauteile werden also eingespart.

Bei einer vorteilhaften Ausgestaltung ist der Bestückungsplatz mit einer Kontaktfläche der zweiten Kontaktflächenanordnung elektrisch leitend verbunden. Von Vorteil ist dabei, dass das auf der zweiten Kontaktflächenanordnung bestückte zweite Leistungsmodul in einfacher Art und Weise elektrisch leitend verbindbar ist mit einem auf dem Bestückungsplatz bestückten elektrischen Bauteil, vorteilhafterweise mittels Leiterbahnen auf der Leiterplatte.

Bei einer vorteilhaften Ausgestaltung ist das erste elektrische Bauteil als Transformator oder Strommesswiderstand oder Optokoppler oder Bremsenansteuerungsmittel ausgeführt. Von Vorteil ist dabei, dass verschiedene elektrische Bauteile zur Steuerung und/oder Versorgung des zweiten Leistungsmoduls auf der Leiterplatte bestückbar sind.

Bei einer vorteilhaften Ausgestaltung weist das Elektrogerät einen Kühlkörper auf, wobei der Kühlkörper wärmeleitend mit dem ersten Leistungsmodul verbunden ist, wobei der Kühlkörper wärmeleitend mit dem zweiten Leistungsmodul verbunden ist. Von Vorteil ist dabei, dass zwei identische Kühlkörper für ein Elektrogerät mit einem Leistungsmodul und ein Elektrogerät mit zwei Leistungsmodulen verwendbar sind. Es ist ein Baukasten von Elektrogeräten mit einer in verschiedenen Varianten verwendbaren Komponente ausführbar. Die Lagerhaltung von verschiedenen Komponenten ist reduzierbar und der Umweltschutz ist verbessert.

Bei einer vorteilhaften Ausgestaltung erstreckt sich der Kühlkörper parallel zur Leiterplattenebene der Leiterplatte vom ersten Leistungsmodul zu der zweiten Kontaktflächenanordnung und ist von der zweiten Kontaktflächenanordnung beabstandet angeordnet. Von Vorteil ist dabei, dass das erste Leistungsmodul zwischen dem Kühlkörper und der Leiterplatte anordenbar ist.

Bei einer vorteilhaften Ausgestaltung ist das zweite Leistungsmodul zwischen dem Kühlkörper und der Leiterplatte angeordnet. Von Vorteil ist dabei, dass das zweite Leistungsmodul in einfacher Art und Weise wärmeleitend verbindbar ist mit dem Kühlkörper. Vorteilhafterweise ist ein einziger Kühlkörper verwendbar zur Entwärmung von zwei Leistungsmodulen.

Bei einer vorteilhaften Ausgestaltung weist die Leiterplatte zwei Ausnehmungen auf und der Kühlkörper weist zwei Gewindebohrungen auf, wobei jedes Leistungsmodul eine Ausnehmung aufweist, wobei ein Schraubmittel durch eine der Ausnehmungen in der Leiterplatte und durch die Ausnehmung in dem jeweiligen Leistungsmodul teilweise hindurchgeführt ist und mit einer der Gewindebohrungen schraubverbunden ist, wobei jeweils eine der Ausnehmungen in der Leiterplatte und jeweils eine der Gewindebohrungen zueinander fluchtend angeordnet sind. Von Vorteil ist dabei, dass jedes Leistungsmodul mittels eines einzigen Schraubmittels mit der Leiterplatte und dem Kühlkörper verbindbar ist. Somit sind Bauteile einsparbar und der Umweltschutz ist verbessert.

Bei einer Ausgestaltung, die nicht zur Erfindung gehört, weist das Elektrogerät ein erstes Gehäuseteil und ein erstes Steckverbinderteil auf, das mittels Leiterbahnen auf der Leiterplatte mit dem ersten Leistungsmodul elektrisch leitend verbunden ist, wobei das erste Gehäuseteil eine Ausnehmung für das erste Steckverbinderteil aufweist, wobei das erste Steckverbinderteil in die Ausnehmung eingesetzt ist. Von Vorteil ist dabei, dass das erste Gehäuseteil zumindest teilweise gehäusebildend ist für das Elektrogerät. Vorteilhafterweise ist das erste Gehäuseteil berührsicher ausgeführt. Es weist also keine Ausnehmungen auf, in die kein Steckverbinder oder ähnliches eingesetzt ist und die groß genug wären, um durch die Ausnehmung in das Elektrogerät hineinzugreifen. Vorteilhafterweise werden also keine Abdeckteile für eine solche Ausnehmung benötigt.

Das Elektrogerät weist eine weitere Leiterplatte, aufweisend weitere Leiterbahnen und zumindest ein Verbindungsmittel, und ein zweites Steckverbinderteil auf, wobei das zweite Leistungsmodul auf der Leiterplatte, insbesondere auf der zweiten Kontaktflächenanordnung, bestückt ist und mittels der Leiterbahnen mit der Durchkontaktierung elektrisch leitend verbunden ist, wobei das zweite Steckverbinderteil auf der weiteren Leiterplatte bestückt ist und mittels der weiteren Leiterbahnen mit dem Verbindungsmittel elektrisch leitend verbunden ist, wobei die Durchkontaktierung mittels eines Kabels elektrisch leitend mit dem Verbindungsmittel verbunden ist. Von Vorteil ist dabei, dass das Elektrogerät kompakt ausführbar ist, da die Leiterplatten beabstandet voneinander anordenbar sind. Dabei sind die Leiterplatten in Normalenrichtung zu einer Leiterplattenebene voneinander beabstandbar, beispielsweise parallel anordenbar.

Vorteilhafterweise ist die Position des zweiten Steckverbinderteils am Elektrogerät unabhängig von der Lage der Leiterplatte im Elektrogerät wählbar.

Bei einer vorteilhaften Ausgestaltung ist ein Endbereich des Kabels in die Durchkontaktierung eingeführt und mit der Durchkontaktierung lötverbunden. Von Vorteil ist dabei, dass das Kabel in einfacher Art und Weise mit der Durchkontaktierung sicher verbindbar ist.

Bei einer vorteilhaften Ausgestaltung ist das Verbindungsmittel auf der weiteren Leiterplatte bestückt. Von Vorteil ist dabei, dass das Verbindungsmittel aus der Leiterplattenebene der weiteren Leiterplatte hervorsteht. Somit ist das Kabel auf das Verbindungsmittel aufsteckbar. Vorteilhafterweise erstreckt sich das Kabel in Querrichtung zur Normalenrichtung der Leiterplattenebene der weiteren Leiterplatte. Somit ist ein Kabelbruch des Kabels bei kompakter Ausführung des Elektrogeräts verhinderbar und die Sicherheit des Elektrogeräts ist verbessert.

Bei einer vorteilhaften Ausgestaltung weist die weitere Leiterplatte eine Leiterplattenebene auf und das Verbindungsmittel kragt von der weiteren Leiterplatte senkrecht zur Normalenrichtung der Leiterplattenebene aus. Von Vorteil ist dabei, dass das Verbindungsmittel sich weiter in den Innenraum des Elektrogerätes hinein erstreckt als die weitere Leiterplatte. Somit ist das Kabel beabstandet von der weiteren Leiterplatte anordenbar. Vorteilhafterweise erstreckt sich das Kabel im Wesentlichen parallel zur Normalenrichtung der Leiterplattenebene.

Bei einer vorteilhaften Ausgestaltung ist ein weiterer Endbereich des Kabels auf das Verbindungsmittel gesteckt. Von Vorteil ist dabei, dass das Kabel in einfacher Art und Weise mit dem Verbindungsmittel sicher verbindbar ist. Vorteilhafterweise ist das Kabel mit dem Verbindungsmittel quetschverbindbar, insbesondere mittels eines Crimpverbinders.

Bei einer vorteilhaften Ausgestaltung ist das Verbindungsmittel als Durchkontaktierung in der weiteren Leiterplatte ausgeführt. Von Vorteil ist dabei, dass die Durchkontaktierung in einem Arbeitsgang mit den weiteren Leiterbahnen auf der weiteren Leiterplatte fertigbar ist. Somit ist der Arbeitsaufwand reduzierbar und der Umweltschutz ist verbessert.

Bei einer vorteilhaften Ausgestaltung ist ein weiterer Endbereich des Kabels in das Verbindungsmittel eingeführt und mit dem Verbindungsmittel lötverbunden. Von Vorteil ist dabei, dass das Kabel in einfacher Art und Weise mit dem Verbindungsmittel sicher verbindbar ist.

Bei einer vorteilhaften Ausgestaltung weist das Elektrogerät zumindest ein zweites Gehäuseteil auf, wobei das zweite Gehäuseteil eine erste Ausnehmung für ein erstes Steckverbinderteil und eine zweite Ausnehmung für ein zweites Steckverbinderteil aufweist, wobei das erste Steckverbinderteil in die erste Ausnehmung eingesetzt ist, wobei das zweite Steckverbinderteil in die zweite Ausnehmung eingesetzt ist. Von Vorteil ist dabei, dass das erste und zweite Steckverbinderteil in einfacher Art und Weise mit dem zweiten Gehäuseteil verbindbar sind, insbesondere klipsverbindbar.

Vorteilhafterweise ist das zweite Gehäuseteil zumindest teilweise gehäusebildend für das Elektrogerät mit zwei Leistungsmodulen. Das zweite Gehäuseteil ist berührsicher ausgeführt. Es weist also keine Ausnehmungen auf, in die kein Steckverbinder oder ähnliches eingesetzt ist und die groß genug wären, um durch die Ausnehmung in das Elektrogerät hineinzugreifen. Vorteilhafterweise werden also keine Abdeckteile für eine solche Ausnehmung benötigt.

Bei einer vorteilhaften Ausgestaltung ist die weitere Leiterplatte lösbar mit dem zweiten Gehäuseteil verbunden. Von Vorteil ist dabei, dass das die weitere Leiterplatte in einfacher Art und Weise austauschbar ist.

**Bei einer Baureihe von vorgenannten Elektrogeräten ist von Vorteil,** dass Elektrogeräte zur Speisung von einem oder zwei Elektromotoren mit identischer Leiterplatte herstellbar sind. Jeder Elektromotor ist unabhängig von dem jeweils anderen Elektromotor aus dem entsprechenden Leistungsmodul speisbar.

Vorteilhafterweise sind zwei Elektromotoren mit unterschiedlicher Leistung speisbar, indem zwei Leistungsmodule mit verschiedener Leistung bestückbar sind.

Zwei identische Leiterplatten sind für ein Elektrogerät zur Speisung von zwei Elektromotoren und für ein Elektrogerät zur Speisung von einem Elektromotor verwendbar. Der Baukasten von Elektrogeräten weist also eine in verschiedenen Varianten des Baukastens verwendbare Leiterplatte auf. Die Lagerhaltung von verschiedenen Komponenten ist reduzierbar und der Umweltschutz ist verbessert.

Bei dem Verfahren zur Herstellung nach Anspruch 12 ist von Vorteil, dass Elektrogeräte zur Speisung von einem oder zwei Elektromotoren mit identischer Leiterplatte herstellbar sind. Jeder Elektromotor ist unabhängig von dem jeweils anderen Elektromotor aus dem entsprechenden Leistungsmodul speisbar.

Vorteilhafterweise sind zwei Elektromotoren mit unterschiedlicher Leistung speisbar, indem zwei Leistungsmodule mit verschiedener Leistung bestückbar sind.

Zwei identische Leiterplatten sind für ein Elektrogerät zur Speisung von zwei Elektromotoren und für ein Elektrogerät zur Speisung von einem Elektromotor verwendbar. Bei dem Verfahren zur Herstellung von zwei Varianten eines Elektrogerätes wird also eine einzige Ausführung der Leiterplatte in verschiedenen Varianten verwendet. Die Lagerhaltung von verschiedenen Komponenten ist reduzierbar und der Umweltschutz ist verbessert.

Die Erfindung wird nun anhand von Abbildungen näher erläutert:
In der Figur 1 ist eine Ausführungsform des erfindungsgemäßen Elektrogeräts in Schrägansicht gezeichnet.
Figur 2 zeigt eine Schnittansicht während der erfindungsgemäßen Herstellung des Elektrogeräts.
In der Figur 3 ist eine bestückte Leiterplatte während der erfindungsgemäßen Herstellung des Elektrogerätes dargestellt.
In der Figur 4 ist eine bestückte Leiterplatte während der erfindungsgemäßen Herstellung des Elektrogerätes dargestellt.

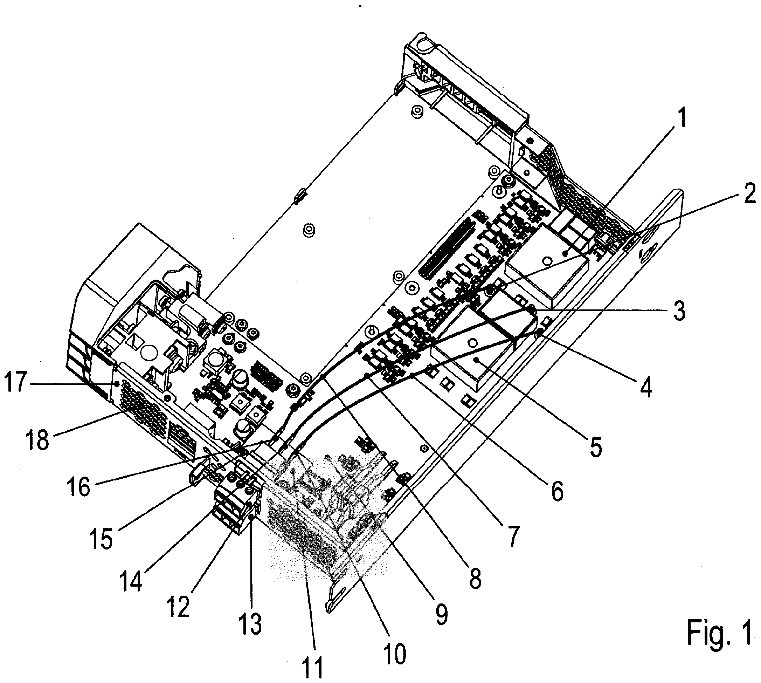

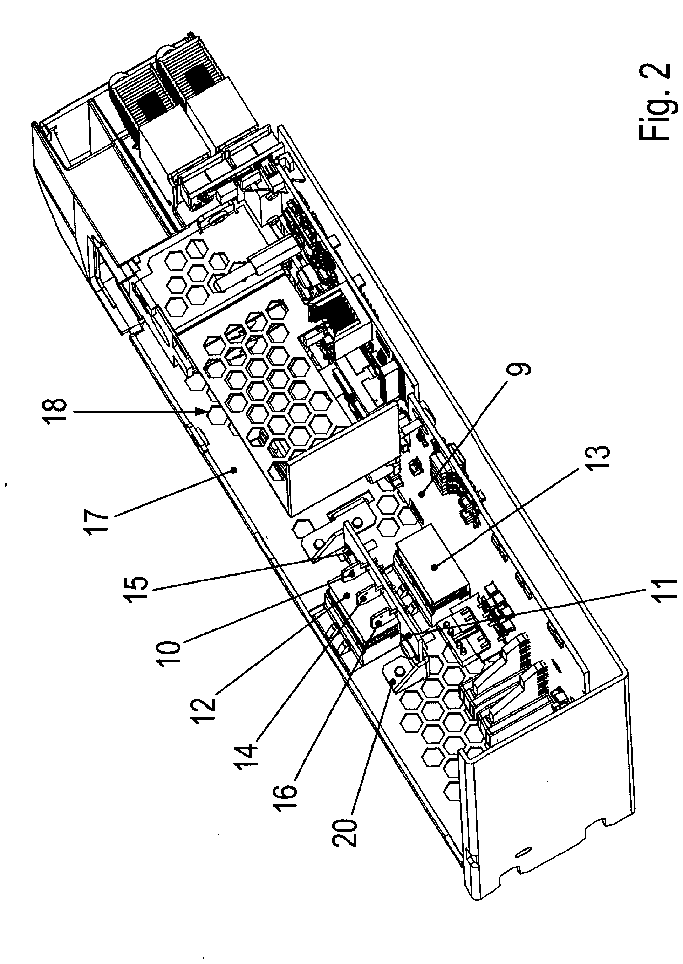

Die in den Figuren 1 bis 3 dargestellte Elektrogeräts, vorzugsweise ein Umrichter, weist die Leiterplatte 9 auf, auf der ein erstes Leistungsmodul 5 und ein zweites Leistungsmodul 1 bestückt sind.

Die Leiterplatte 9 weist Kontaktflächen 41 zur elektrischen Kontaktierung der Leistungsmodule (1, 5) auf. Erste Kontaktflächen zur Kontaktierung des ersten Leistungsmoduls 5 sind als eine erste Kontaktflächenanordnung angeordnet. Zweite Kontaktflächen 41 zur Kontaktierung des zweiten Leistungsmoduls 1 sind als eine zweite Kontaktflächenanordnung angeordnet.

Jede Kontaktflächenanordnung weist jeweils mindestens fünf Kontaktflächen 41 auf, vorzugsweise sieben bis elf Kontaktflächen, insbesondere elf Kontaktflächen. Die erste und zweite Kontaktflächenanordnung sind identisch angeordnet. Dabei ist die erste Kontaktflächenanordnung mittels Translation und Rotation in der Leiterplattenebene der Leiterplatte 9 in die zweite Kontaktflächenanordnung überführbar, so dass die erste und zweite Kontaktflächenanordnung einander überdecken. Vorzugsweise weisen die erste und die zweite Kontaktflächenanordnung eine identische Anzahl von Kontaktflächen 41 auf.

Die Kontaktflächen sind als Durchkontaktierungen ausführbar.

Jedes Leistungsmodul (1, 5) weist einen Wechselrichter, umfassend steuerbare Halbleiterleistungsschalter, insbesondere IGBTs, auf. Vorzugsweise weisen das erste Leistungsmodul 5 und das zweite Leistungsmodul 1 verschiedene Leistungen auf und sind zur Speisung von unterschiedlichen Elektromotoren geeignet.

Das Elektrogerät weist einen Gleichrichter und einen aus diesem gespeisten Gleichspannungszwischenkreis auf. Vorzugsweise sind das erste und zweite Leistungsmodul (1, 5) aus einem einzigen gemeinsamen Gleichspannungszwischenkreis gespeist.

Das erste Leistungsmodul 5 ist mittels Leiterbahnen auf der Leiterplatte 9 mit einem ersten Steckverbinderteil 13 elektrisch leitend verbunden. Das erste Steckverbinderteil 13 ist zum Verbinden mit einem ersten Gegensteckverbinderteil eingerichtet. Beispielsweise ist das erste Gegensteckverbinderteil mit einem ersten Elektromotor elektrisch leitend verbunden, so dass der erste Elektromotor speisbar ist mittels des Elektrogerätes, insbesondere speisbar aus dem ersten Leistungsmodul 5.

Ein Steckverbinderteil (12, 13) zum Anschluss eines Elektromotors ist auch als Motoranschlussteil bezeichenbar.

Das zweite Leistungsmodul 1 ist mittels Leiterbahnen auf der Leiterplatte 9 mit drei Durchkontaktierungen (2, 3, 4) in der Leiterplatte 9 verbunden. Dazu weist das zweite Leistungsmodul 1 elektrische Kontaktmittel auf, die mit den Leiterbahnen lötverbunden sind.

Die Durchkontaktierungen (2, 3, 4) sind elektrisch leitend mit jeweils einem Kabel (6, 7, 8) verbunden. Dazu ist jeweils ein erster Endbereich jedes Kabels (6, 7, 8) in die jeweilige Durchkontaktierung (2, 3, 4) eingeführt und mit der jeweiligen Durchkontaktierung (2, 3, 4) lötverbunden.

Ein jeweiliger zweiter Endbereich jedes Kabels (6, 7, 8) ist elektrisch leitend mit einem jeweiligen Verbindungsmittel (10, 14, 16) verbunden. Die Verbindungsmittel (10, 14, 16) sind auf einer weiteren Leiterplatte 11 angeordnet, insbesondere bestückt. Auf der weiteren Leiterplatte 11 ist ein zweites Steckverbinderteil 12 bestückt. Die Verbindungsmittel (10, 14, 16) sind mittels weiterer Leiterbahnen auf der weiteren Leiterplatte 11 elektrisch leitend mit dem zweiten Steckverbinderteil 12 verbunden. Dazu weisen die Verbindungsmittel (10, 14, 16) und das zweite Steckverbinderteil 12 elektrische Kontaktmittel auf, die mit den weiteren Leiterbahnen lötverbunden sind.

Das zweite Steckverbinderteil 12 ist zum Verbinden mit einem zweiten Gegensteckverbinderteil eingerichtet. Das zweite Gegensteckverbinderteil ist beispielsweise mit einem zweiten Elektromotor elektrisch leitend verbunden, so dass der zweite Elektromotor speisbar ist mittels des Elektrogerätes, insbesondere speisbar aus dem zweiten Leistungsmodul 1.

Das in Figur 1 dargestellte Elektrogerät weist zumindest ein zweites Gehäuseteil 17 auf. Durch eine erste Ausnehmung in dem zweiten Gehäuseteil 17 ist das erste Steckverbinderteil 13 teilweise hindurchgeführt und mit dem zweiten Gehäuseteil 17 und/oder der Leiterplatte 9 verbunden, insbesondere kraftschlüssig verbunden, vorzugsweise klemmverbunden. Vorzugsweise ist das erste Steckverbinderteil 13 in das zweite Gehäuseteil 17 eingesteckt.

Das zweite Gehäuseteil 17 weist Ausnehmungen zur Belüftung 18 auf. Die Ausnehmungen zur Belüftung 18 sind zur Belüftung, insbesondere zur konvektiven Kühlung, des Elektrogerätes eingerichtet.

Das zweite Gehäuseteil 17 ist als Stanzbiegeteil ausgeführt, insbesondere als Stanzbiegeblechteil.

Das zweite Steckverbinderteil 12 ist durch eine zweite Ausnehmung in dem zweiten Gehäuseteil 17 teilweise hindurchgeführt und mit dem zweiten Gehäuseteil 17 und/oder der weiteren Leiterplatte 11 verbunden, insbesondere kraftschlüssig verbunden, vorzugsweise klemmverbunden. Vorzugsweise ist das zweite Steckverbinderteil 12 in das zweite Gehäuseteil 17 eingesteckt.

Die erste Ausnehmung, die zweite Ausnehmung und die Ausnehmungen zur Belüftung 18 sind als durchgehende Ausnehmungen ausgeführt.

Die weitere Leiterplatte 11 ist lösbar mit dem zweiten Gehäuseteil 17 verbunden. Dazu ist zumindest ein Halteteil 20 mit dem zweiten Gehäuseteil 17 verbunden, insbesondere vernietet. Das Halteteil 20 weist zumindest eine Bohrung auf, durch die ein Schraubteil 15 hindurchführbar ist. Die weitere Leiterplatte 11 weist zumindest eine Bohrung auf, durch die das Schraubteil 15 hindurchführbar ist. Mittels des durch die Bohrungen hindurchgeführten Schraubteils 15, das mittels einer Mutter fixierbar ist, ist die weitere Leiterplatte 11 lösbar verbunden mit dem Halteteil 20.

Das Halteteil 20 ist als Stanzbiegeteil, insbesondere Stanzbiegeblechteil, ausgeführt. Das zweite Gehäuseteil 17 spannt eine Ebene auf. Vorzugsweise ist die weitere Leiterplatte 11 derart mit dem zweiten Gehäuseteil 17 verbunden, dass diese Ebene in einem nichtverschwindenden Winkel zur Leiterplattenebene der weiteren Leiterplatte 11 angeordnet ist, vorzugsweise ist der Normalenvektor der Leiterplattenebene der weiteren Leiterplatte 11 im rechten Winkel zum Normalenvektor der Ebene des zweiten Gehäuseteils 17 angeordnet. Dabei ist das auf der weiteren Leiterplatte 11 angeordnete Halteteil 20 beabstandet von dem zweiten Gehäuseteil 17 angeordnet.

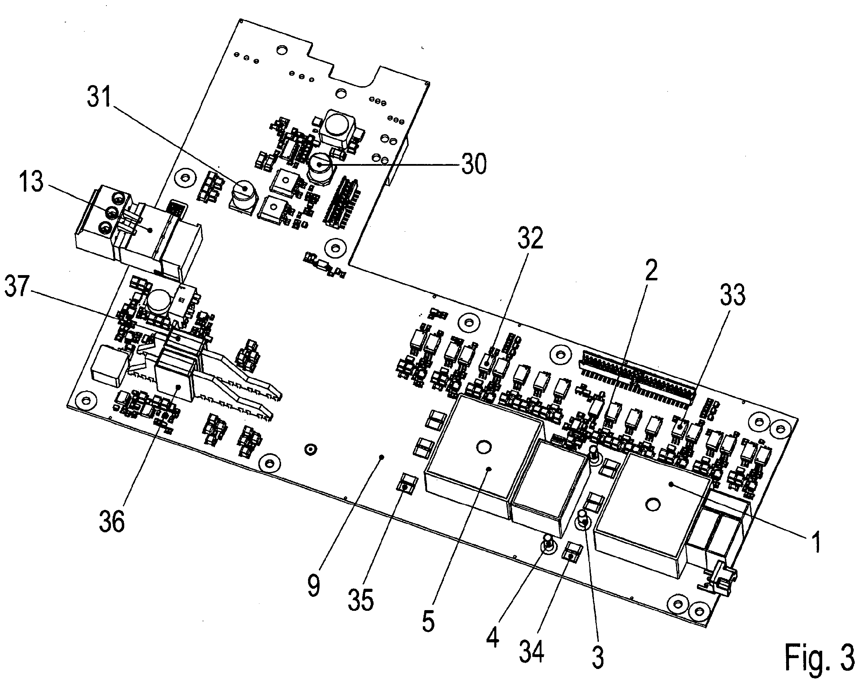

In Figur 3 ist die bestückte Leiterplatte 9 dargestellt.

Die Leiterplatte 9 ist mit dem ersten Leistungsmodul 5 und dem zweiten Leistungsmodul 1, mit Strommesswiderständen 35 und weiteren Strommesswiderständen 34, mit Optokopplern 32 und weiteren Optokopplern 33, mit einem Transformator 37 und einem weiteren Transformator 36 und mit einem Bremsenansteuerungsmittel 30 und einem weiteren Bremsenansteuerungsmittel 31 bestückt, wobei die Bremsenansteuerungsmittel (30, 31) jeweils einen Transistor aufweisen.

Die Optokoppler 32 sind mittels auf der Leiterplatte 9 angeordneter Leiterbahnen elektrisch leitend mit dem Transformator 37 verbunden und werden aus diesem gespeist. Mittels der Optokoppler 32 wird das erste Leistungsmodul 5 gesteuert. Dazu sind die Optokoppler 32 mittels auf der Leiterplatte 9 angeordneter Leiterbahnen elektrisch leitend mit dem Leistungsmodul 5 verbunden. Die Strommesswiderstände 35 messen den Ausgangsstrom des Leistungsmoduls 5. Dazu sind die Strommesswiderstände 35 mittels auf der Leiterplatte 9 angeordneter Leiterbahnen elektrisch leitend mit dem ersten Leistungsmodul 5 verbunden.

Mittels des Elektrogerätes ist eine erste Bremse ansteuerbar, dazu weist das Elektrogerät ein Bremsenansteuerungsmittel 30 auf.

Die weiteren Optokoppler 33 sind mittels auf der Leiterplatte 9 angeordneter Leiterbahnen elektrisch leitend mit dem weiteren Transformator 36 verbunden und werden aus diesem gespeist. Mittels der weiteren Optokoppler 33 wird das zweite Leistungsmodul 1 gesteuert. Dazu sind die weiteren Optokoppler 33 mittels auf der Leiterplatte 9 angeordneter Leiterbahnen elektrisch leitend mit dem zweiten Leistungsmodul 1 verbunden.

Die weiteren Strommesswiderstände 34 messen den Ausgangsstrom des zweiten Leistungsmoduls 1. Dazu sind die weiteren Strommesswiderstände 34 mittels auf der Leiterplatte 9 angeordneter Leiterbahnen elektrisch leitend mit dem zweiten Leistungsmodul 1 verbunden.

Mittels des erfindungsgemäßen Elektrogerätes ist eine zweite Bremse ansteuerbar, dazu weist das Elektrogerät ein weiteres Bremsenansteuerungsmittel 31 auf.

Die Leiterplatte 9 weist zwei Ausnehmungen 40 auf, durch die jeweils ein Schraubmittel teilweise hindurchführbar ist zur Verbindung eines jeweiligen Leistungsmoduls (1, 5) mit der Leiterplatte 9. Dazu weist das jeweilige Leistungsmodul (1, 5) eine Ausnehmung auf, durch die das Schraubmittel teilweise hindurchführbar ist.

Das Elektrogerät weist einen nicht dargestellten Kühlkörper auf, der wärmeleitend mit dem ersten Leistungsmodul 5 und dem zweiten Leistungsmodul 1 verbunden ist. Vorteilhafterweise weist der Kühlkörper Gewindebohrungen auf, insbesondere jeweils eine Gewindebohrung für jedes Leistungsmodul (1, 5). Somit ist das Schraubmittel durch eine der Ausnehmungen 40 in der Leiterplatte 9 und die Ausnehmung in dem jeweiligen Leistungsmodul (1, 5) hindurchführbar und mit dem Kühlkörper schraubverbindbar. Die Leistungsmodule (1, 5) sind zwischen dem Kühlkörper und der Leiterplatte 9 angeordnet.

Der Kühlkörper weist Kühlrippen und/oder Kühlfinger auf. Vorzugsweise weist das Elektrogerät einen Lüfter auf, mittels dessen ein Kühlluftstrom entlang der Kühlrippen und/oder Kühlrippen gefördert wird.

Somit sind die in Figur 1, 2 und 3 dargestellten Elektrogeräte zur Speisung und/oder Ansteuerung von zwei unabhängigen Elektromotoren mit jeweils einer Bremse eingerichtet.

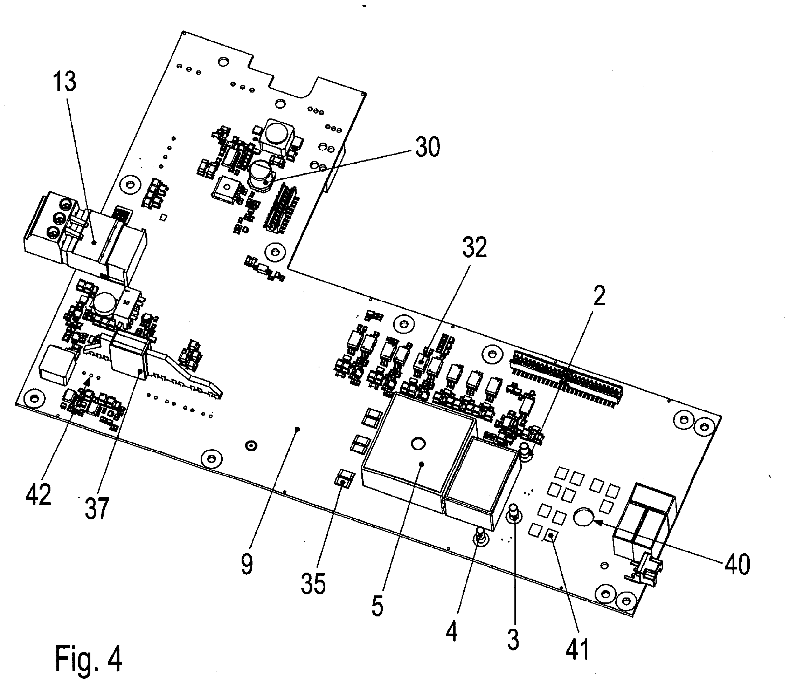

Das in Figur 4 dargestellte Elektrogerät ist zur Ansteuerung von einem einzigen Elektromotor mit einer Bremse geeignet.

Die in Figur 4 dargestellte Leiterplatte 9 weist Leiterbahnen auf, die identisch angeordnet sind wie die Leiterbahnen der in Figur 3 dargestellten Leiterplatte 9. Die Leiterplatten 9 des in Figur 3 und 4 dargestellten Elektrogerätes sind also identisch ausgeführt.

Die in Figur 4 dargestellte Leiterplatte 9 ist mit einem einzigen ersten Leistungsmodul 5, Strommesswiderständen 35, Optokopplern 32, einem Transformator 37 und einem Bremsenansteuerungsmittel 30 bestückt. Die zweite Kontaktflächenanordnung ist also nicht bestückt.

Die Leiterplatte 9 weist Durchkontaktierungen (2, 3, 4) auf, die mittels Leiterbahnen mit einer jeweiligen Kontaktfläche 41 der zweiten Kontaktflächenanordnung verbunden sind. Die Kontaktflächen 41 sind zur elektrischen Kontaktierung des zweiten Leistungsmoduls 1 geeignet. Bei dem in Figur 4 dargestellten Elektrogerät enden die Durchkontaktierungen (2, 3, 4) und die Kontaktflächen 41 blind. Die Durchkontaktierungen (2, 3, 4) und die Kontaktflächen 41 sind von elektrischen Bauteilen des Elektrogeräts elektrisch isoliert angeordnet.

Während der erfindungsgemäßen Herstellung ist zuerst nur das erste Leistungsmodul 5 auf der Leiterplatte 9 bestückt. Eine Ausnehmung 40 in der Leiterplatte 9, die zur Verbindung des zweiten Leistungsmoduls 1 mit der Leiterplatte 9 geeignet ist, ist beabstandet von dem ersten Leistungsmodul 5 angeordnet.

Das in Figur 4 dargestellte Elektrogerät weist einen Kühlkörper auf. Das erste Leistungsmodul 5 ist wärmeleitend mit dem Kühlkörper verbunden. Das erste Leistungsmodul 5 ist zwischen dem Kühlkörper und der Leiterplatte 9 angeordnet. Eine Gewindebohrung in dem Kühlkörper ist beabstandet von dem ersten Leistungsmodul 5 angeordnet.

Das in Figur 4 dargestellte Elektrogerät weist keine weiteren Optokoppler 33 auf. Die für die weiteren Optokoppler 33 vorgesehenen Steckplätze auf der Leiterplatte 9 sind nicht bestückt.

Die Leiterplatte 9 weist Ausnehmungen 42 auf, die zur Aufnahme von Anschlusselementen eines Transformators (36, 37) geeignet sind. Diese Ausnehmungen 42 sind beabstandet von Anschlusselementen des Transformators (37) angeordnet.

Das in Figur 4 dargestellte Elektrogerät weist keine weiteren Strommesswiderstände 34 auf. Die auf der Leiterplatte 9 angeordneten Leiterbahnen zur elektrischen Verbindung der weiteren Strommesswiderstände 34 mit dem weiteren Leistungsmodul 1 enden bei dem in Figur 4 dargestellten Elektrogerät blind. Bestückungsplätze auf der Leiterplatte 9, die für die weiteren Strommesswiderstände geeignet sind, sind nicht bestückt.

Das in Figur 4 dargestellte Elektrogerät weist kein weiteres Bremsenansteuerungsmittel 31 auf. Ein Bestückungsplatz auf der Leiterplatte 9, der für das weitere Bremsenansteuerungsmittel 31 geeignet ist, ist also nicht bestückt. Somit ist das in Figur 4 dargestellte Elektrogerät zur Ansteuerung einer einzigen Bremse geeignet.

Der Bestückungsplatz ist als Durchkontaktierung, Steckplatz oder Ausnehmung ausführbar.

Das in Figur 4 dargestellte Elektrogerät weist zumindest ein erstes Gehäuseteil auf. Dabei ist das erste Gehäuseteil zu dem zweiten Gehäuseteil 17 verschieden ausgeführt. Durch eine Ausnehmung in dem ersten Gehäuseteil ist das erste Steckverbinderteil 13 teilweise hindurchgeführt und mit dem ersten Gehäuseteil und/oder der Leiterplatte 9 verbunden, insbesondere kraftschlüssig verbunden, vorzugsweise klemmverbunden. Vorzugsweise ist das Steckverbinderteil 13 in das erste Gehäuseteil eingesteckt.

Das erste Gehäuseteil weist Ausnehmungen zur Belüftung auf. Die Ausnehmungen zur Belüftung sind zur Belüftung, insbesondere zur konvektiven Kühlung, des Elektrogerätes eingerichtet.

Das erste Gehäuseteil ist als Stanzbiegeteil ausgeführt, insbesondere als Stanzbiegeblechteil.

Die Ausnehmung und die Ausnehmungen zur Belüftung sind als durchgehende Ausnehmungen ausgeführt.

### Bezugszeichenliste

1 Leistungsmodul
2 Durchkontaktierung
3 Durchkontaktierung
4 Durchkontaktierung
5 Leistungsmodul
6 Kabel
7 Kabel
8 Kabel
9 Leiterplatte
10 Verbindungsmittel
11 Leiterplatte
12 Steckverbinderteil
13 Steckverbinderteil
14 Verbindungsmittel
15 Schraubteil
16 Verbindungsmittel
17 Gehäuseteil
18 Ausnehmung zur Belüftung
20 Halteteil
30 Bremsenansteuerungsmittel, insbesondere Transistor
31 Bremsenansteuerungsmittel, insbesondere Transistor
32 Optokoppler
33 Optokoppler
34 Strommesswiderstand
35 Strommesswiderstand
36 Transformator
37 Transformator
40 Ausnehmung
41 Kontaktfläche
42 Ausnehmung

## Patentansprüche

1. Elektrogerät, aufweisend eine Leiterplatte (9) mit Leiterbahnen,
wobei die Leiterplatte (9) zwei gleichartige und/oder identische Kontaktflächenanordnungen aufweist,
wobei eine erste der Kontaktflächenanordnungen mit einem ersten Leistungsmodul (5) bestückt ist und eine zweite Kontaktflächenanordnung mit einem zweiten Leistungsmodul (1) bestückt ist,
wobei das Elektrogerät
- eine weitere Leiterplatte (11), aufweisend weitere Leiterbahnen und Verbindungsmittel (10, 14, 16),
- und ein zweites Steckverbinderteil (12) aufweist,
wobei das zweite Leistungsmodul (1) mittels Kontaktflächen (41) der zweiten Kontaktflächenanordnung und der Leiterbahnen mit Durchkontaktierungen (2, 3, 4) elektrisch leitend verbunden ist,
wobei das zweite Steckverbinderteil (12) auf der weiteren Leiterplatte (11) bestückt ist und mittels der weiteren Leiterbahnen mit den Verbindungsmitteln (10, 14, 16) elektrisch leitend verbunden ist,
wobei die Durchkontaktierungen (2, 3, 4) jeweils mittels eines Kabels (6, 7, 8) elektrisch leitend mit den Verbindungsmitteln (10, 14, 16) verbunden sind.

2. Elektrogerät nach Anspruch 1,
**dadurch gekennzeichnet, dass**
elektrische Bauteile auf der Leiterplatte (9) bestückt sind,
wobei die zweite Kontaktflächenanordnung elektrisch isoliert von allen diesen elektrischen Bauteilen angeordnet ist.

3. Elektrogerät nach mindestens einem der vorangegangenen Ansprüche,
**dadurch gekennzeichnet, dass**
die Leiterplatte (9) einen Bestückungsplatz aufweist, der zur elektrischen Kontaktierung eines zu einem ersten elektrischen Bauteil, insbesondere der elektrischen Bauteile, gleichartigen elektrischen Bauteiles geeignet ist,
wobei der Bestückungsplatz beabstandet und/oder elektrisch isoliert angeordnet ist von dem ersten elektrischen Bauteil,
insbesondere wobei der Bestückungsplatz mit einer Kontaktfläche (41) der zweiten Kontaktflächenanordnung elektrisch leitend verbunden ist.

4. Elektrogerät nach mindestens einem der vorangegangenen Ansprüche,
**dadurch gekennzeichnet, dass**
das erste elektrische Bauteil als Transformator (37) oder Strommesswiderstand (35) oder Optokoppler (32) oder Bremsenansteuerungsmittel (30) ausgeführt ist.

5. Elektrogerät nach mindestens einem der vorangegangenen Ansprüche,
**dadurch gekennzeichnet, dass**
das Elektrogerät einen Kühlkörper aufweist,
wobei der Kühlkörper wärmeleitend mit dem ersten Leistungsmodul (5) verbunden ist,
wobei der Kühlkörper wärmeleitend mit dem zweiten Leistungsmodul (1) verbunden ist,
insbesondere wobei der Kühlkörper sich parallel zur Leiterplattenebene der Leiterplatte (9) vom ersten Leistungsmodul (5) zu der zweiten Kontaktflächenanordnung erstreckt und von der zweiten Kontaktflächenanordnung beabstandet angeordnet ist, insbesondere so dass das zweite Leistungsmodul (1) zwischen dem Kühlkörper und der Leiterplatte (9) angeordnet ist.

6. Elektrogerät nach mindestens einem der vorangegangenen Ansprüche,
**dadurch gekennzeichnet, dass**
die Leiterplatte (9) zwei Ausnehmungen (40) aufweist und der Kühlkörper zwei Gewindebohrungen aufweist,
wobei jedes Leistungsmodul (1, 5) eine Ausnehmung aufweist,
wobei ein Schraubmittel durch eine der Ausnehmungen (40) in der Leiterplatte (9) und durch die Ausnehmung in dem jeweiligen Leistungsmodul (1, 5) teilweise hindurchgeführt ist und mit einer der Gewindebohrungen schraubverbunden ist,
wobei jeweils eine der Ausnehmungen (40) in der Leiterplatte (9) und jeweils eine der Gewindebohrungen zueinander fluchtend angeordnet sind.

7. Elektrogerät nach mindestens einem der vorangegangenen Ansprüche,
**dadurch gekennzeichnet, dass**
ein Endbereich des Kabels (6, 7, 8) in die Durchkontaktierung (2, 3, 4) eingeführt ist und mit der Durchkontaktierung (2, 3, 4) lötverbunden ist.

8. Elektrogerät nach mindestens einem der vorangegangenen Ansprüche,
**dadurch gekennzeichnet, dass**
das Verbindungsmittel (10, 14, 16) auf der weiteren Leiterplatte (11) bestückt ist,
insbesondere wobei die weitere Leiterplatte (11) eine Leiterplattenebene aufweist und das Verbindungsmittel (10, 14, 16) von der weiteren Leiterplatte (11) senkrecht zur Normalenrichtung der Leiterplattenebene auskragt,
insbesondere wobei ein weiterer Endbereich des Kabels (6, 7, 8) auf das Verbindungsmittel (10, 14, 16) gesteckt ist.

9. Elektrogerät nach mindestens einem der Ansprüche 1 bis 8,
**dadurch gekennzeichnet, dass**
das Verbindungsmittel (10, 14, 16) als Durchkontaktierung in der weiteren Leiterplatte (11) ausgeführt ist,
insbesondere wobei ein weiterer Endbereich des Kabels (6, 7, 8) in das Verbindungsmittel (10, 14, 16) eingeführt ist und mit dem Verbindungsmittel (10, 14, 16) lötverbunden ist.

10. Elektrogerät nach mindestens einem der Ansprüche 1 bis 9,
**dadurch gekennzeichnet, dass**
das Elektrogerät zumindest ein Gehäuseteil (17) aufweist,
wobei das Gehäuseteil (17) eine erste Ausnehmung für ein erstes Steckverbinderteil (13) und eine zweite Ausnehmung für ein zweites Steckverbinderteil (12) aufweist,
wobei das erste Steckverbinderteil (13) in die erste Ausnehmung eingesetzt ist,
wobei das zweite Steckverbinderteil (12) in die zweite Ausnehmung eingesetzt ist, insbesondere wobei die zweite Leiterplatte (11) lösbar mit dem Gehäuseteil (17) verbunden ist.

11. Baureihe von Elektrogeräten,
wobei die Baureihe zumindest ein Elektrogerät nach mindestens einem der vorangegangenen Ansprüche aufweist.

12. Verfahren zur Herstellung eines Elektrogerätes, das eine Leiterplatte (9) aufweist, die
- Leiterbahnen und
- zwei gleichartige und/oder identische Kontaktflächenanordnungen aufweist,
wobei eine erste Kontaktflächenanordnung mit einem ersten Leistungsmodul (5) bestückbar ist,
wobei eine zweite Kontaktflächenanordnung mit einem zweiten Leistungsmodul (1) bestückbar ist,
wobei die Leiterplatte (9) Durchkontaktierungen (2, 3, 4) aufweist, die mittels Leiterbahnen auf der Leiterplatte (9) elektrisch leitend mit jeweils einer Kontaktfläche (41) der zweiten Kontaktflächenanordnung verbunden ist, und wobei
zuerst das Elektrogerät ein erstes Gehäuseteil aufweist, wobei das erste Gehäuseteil eine einzige Ausnehmung für ein Motoranschlussteil aufweist,
wobei zur Herstellung des Elektrogeräts das erste Leistungsmodul (5) auf der ersten Kontaktflächenanordnung bestückt wird und mit einem ersten Motoranschlussteil elektrisch leitend verbunden wird, welches in die Ausnehmung des ersten Gehäuseteils eingesetzt wird und wobei die Durchkontaktierungen (2, 3, 4) nicht elektrisch leitend mit einem Motoranschlussteil verbunden sind,
wobei danach das Elektrogerät ein zweites Gehäuseteil (17) aufweist, wobei das zweite Gehäuseteil (17) eine erste Ausnehmung für ein erstes Motoranschlussteil und eine zweite Ausnehmung für ein zweites Motoranschlussteil aufweist,
wobei zur Herstellung des Elektrogeräts das erste Leistungsmodul (5) auf der ersten Kontaktflächenanordnung bestückt wird und
mit einem ersten Motoranschlussteil elektrisch leitend verbunden wird, welches in die Ausnehmung des ersten Gehäuseteils eingesetzt wird,
und zusätzlich ein zweites Leistungsmodul (1) auf der zweiten Kontaktflächenanordnung bestückt wird, welches mit einem zweiten Motoranschlussteil elektrisch leitend verbunden wird, welches in die zweite Ausnehmung des zweiten Gehäuseteils (17) eingesetzt wird, das an der Stelle des ersten Gehäuseteils im Elektrogerät eingebaut wird, wobei das erste Motoranschlussteil in die erste Ausnehmung des zweiten Gehäuseteils (17) eingesetzt wird, und wobei eine weitere Leiterplatte (11), aufweisend das zweite Motoranschlussteil, weitere Leiterbahnen und Verbindungsmittel (10, 14, 16) vorgesehen wird, und die Durchkontaktierungen (2, 3, 4) jeweils mittels eines Kabels (6, 7, 8) elektrisch leitend mit den Verbindungsmitteln (10, 14, 16)) verbunden wird.

## Claims

1. Electrical device comprising a printed circuit board (9) having conductive tracks,
wherein the printed circuit board (9) comprises two similar and/or identical contact surface arrangements,
wherein a first of the contact surface arrangements is equipped with a first power module (5) and a second contact surface arrangement is equipped with a second power module (1), wherein the electrical device comprises
- a further printed circuit board (11) comprising further conductive tracks and connection means (10, 14, 16),
- and a second plug-in connector part (12),
wherein the second power module (1) is connected in an electrically conductive manner to vias (2, 3, 4) by means of contact surfaces (41) of the second contact surface arrangement and the conductive tracks,
wherein the second plug-in connector part (12) is placed on the further printed circuit board (11) and is connected in an electrically conductive manner to the connection means (10, 14, 16) by means of the further conductive tracks,
wherein the vias (2, 3, 4) are connected in an electrically conductive manner to the connection means (10, 14, 16) by means of a respective cable (6, 7, 8).

2. Electrical device according to claim 1,
**characterised in that**
electrical components are placed on the printed circuit board (9),
the second contact surface arrangement being arranged so as to be electrically insulated from all said electrical components.

3. Electrical device according to at least one of the preceding claims,
**characterised in that**
the printed circuit board (9) comprises a placement site, which is suitable for electrically contacting an electrical component that is similar to a first electrical component, in particular to the electrical components,
the placement site being arranged at a distance from and/or so as to be electrically insulated from the first electrical component,
the placement site in particular being connected in an electrically conductive manner to a contact surface (41) of the second contact surface arrangement.

4. Electrical device according to at least one of the preceding claims,
**characterised in that**
the first electrical component is configured as a transformer (37), a shunt (35), an optocoupler (32) or a brake actuation means (30).

5. Electrical device according to at least one of the preceding claims,
**characterised in that**
the electrical device comprises a cooling member,
the cooling member being connected in a heat-conducting manner to the first power module (5),
the cooling member being connected in a heat-conducting manner to the second power module (1),
the cooling member in particular extending from the first power module (5) towards the second contact surface arrangement in parallel with the printed circuit board plane of the printed circuit board (9), and being arranged at a distance from the second contact surface arrangement, in particular such that the second power module (1) is arranged between the cooling member and the printed circuit board (9).

6. Electrical device according to at least one of the preceding claims,
**characterised in that**
the printed circuit board (9) comprises two recesses (40) and the cooling member comprises two threaded holes,
each power module (1, 5) comprising a recess,
a screw means being guided in part through one of the recesses (40) in the printed circuit board (9) and through the recess in the respective power module (1, 5) and being screw-connected to one of the threaded holes,
one of the recesses (40) in the printed circuit board (9) being arranged in alignment with one of the threaded holes in each case.

7. Electrical device according to at least one of the preceding claims,
**characterised in that**
an end region of the cable (6, 7, 8) is introduced into the via (2, 3, 4) and solder-connected to the via (2, 3, 4).

8. Electrical device according to at least one of the preceding claims,
**characterised in that**
the connection means (10, 14, 16) is placed on the further printed circuit board (11),
the further printed circuit board (11) in particular comprising a printed circuit board plane, and the connection means (10, 14, 16) protruding from the further printed circuit board (11) perpendicularly to the normal direction of the printed circuit board plane,
a further end region of the cable (6, 7, 8) in particular being plugged into the connection means (10, 14, 16).

9. Electrical device according to at least one of claims 1 to 8,
**characterised in that**
the connection means (10, 14, 16) is configured as a via in the further printed circuit board (11),
a further end region of the cable (6, 7, 8) in particular being introduced into the connection means (10, 14, 16) and being solder-connected to the connection means (10, 14, 16).

10. Electrical device according to at least one of claims 1 to 9,
**characterised in that**
the electrical device comprises at least one housing part (17),
the housing part (17) comprising a first recess for a first plug-in connector part (13) and a second recess for a second plug-in connector part (12),
the first plug-in connector part (13) being inserted into the first recess,
the second plug-in connector part (12) being inserted into the second recess,
the second printed circuit board (11) in particular being releasably connected to the housing part (17).

11. Product line of electrical devices,
wherein the product line comprises at least one electrical device according to at least one of the preceding claims.

12. Method for producing an electrical device comprising a printed circuit board (9) which comprises
- conductive tracks and
- two similar and/or identical contact surface arrangements,
wherein a first contact surface arrangement can be equipped with a first power module (5), wherein a second contact surface arrangement can be equipped with a second power module (1),
wherein the printed circuit board (9) comprises vias (2, 3, 4) which are connected in an electrical conductive manner to a respective contact surface (41) of the second contact surface arrangement by means of conductive tracks on the printed circuit board (9), and wherein
first, the electrical device comprises a first housing part, wherein the first housing part comprises a single recess for a motor terminal part,
wherein, in order to produce the electrical device, the first power module (5) is placed on the first contact surface arrangement and is connected in an electrically conductive manner to a first motor terminal part, which is inserted into the recess of the first housing part, and
wherein the vias (2, 3, 4) are not connected to a motor terminal part in an electrically conductive manner,
wherein, thereafter, the electrical device comprises a second housing part (17), wherein the second housing part (17) comprises a first recess for a first motor terminal part and a second recess for a second motor terminal part,
wherein, in order to produce the electrical device, the first power module (5) is placed on the first contact surface arrangement and is connected in an electrically conductive manner to a first motor terminal part, which is inserted into the recess of the first housing part,
and additionally a second power module (1) is placed on the second contact surface arrangement and is connected in an electrically conductive manner to a second motor terminal part, which is inserted into the second recess of the second housing part (17), which is installed in the electrical device at the location of the first housing part, wherein the first motor terminal part is inserted into the first recess of the second housing part (17), and wherein a further printed circuit board (11) comprising the second motor terminal part, further conductive tracks and connection means (10, 14, 16) is provided, and the vias (2, 3, 4) are connected in an electrically conductive manner to the connection means (10, 14, 16) by means of a respective cable (6, 7, 8).

## Revendications

1. Appareil électrique, présentant une carte de circuits imprimés (9) comprenant des pistes conductives,
la carte de circuits imprimés (9) présentant deux ensembles de surfaces de contact de même type et/ou identiques,
un premier des ensembles de surfaces de contact étant équipé d'un premier module de puissance (5), et un deuxième ensemble de surfaces de contact étant équipé d'un deuxième module de puissance (1),
l'appareil électrique présentant
- une autre carte de circuits imprimés (11) présentant d'autres pistes conductives et moyens de liaison (10, 14, 16),
- et une deuxième pièce formant connecteur enfichable (12),
le deuxième module de puissance (1) étant relié de manière électriquement conductrice à des dispositifs d'interconnexion (2, 3, 4) à l'aide des surfaces de contact (41) du deuxième ensemble de surfaces de contact et des pistes conductives,
la deuxième pièce formant connecteur enfichable (12) équipant l'autre carte de circuits imprimés (11) et étant reliée de manière électriquement conductrice aux moyens de liaison (10, 14, 16) à l'aide des autres pistes conductives,
les dispositifs d'interconnexion (2, 3, 4) étant respectivement reliés de manière électriquement conductrice aux moyens de liaison (10, 14, 16) à l'aide d'un câble (6, 7, 8).

2. Appareil électrique selon la revendication 1, **caractérisé en ce que** des composants électriques équipent la carte de circuits imprimés (9),
le deuxième ensemble de surfaces de contact étant disposé de manière électriquement isolée de tous ces composants électriques.

3. Appareil électrique selon au moins l'une des revendications précédentes, **caractérisé en ce que** la carte de circuits imprimés (9) présente un emplacement d'équipement qui convient à la mise en contact électrique avec un composant électrique de même type qu'un premier composant électrique, en particulier parmi les composants électriques,
l'emplacement d'équipement étant disposé à distance et/ou de manière électriquement isolée par rapport au premier composant électrique,
l'emplacement d'équipement étant en particulier relié de manière électriquement conductrice à une surface de contact (41) du deuxième ensemble de surfaces de contact.

4. Appareil électrique selon au moins l'une des revendications précédentes, **caractérisé en ce que** le premier composant électrique est réalisé sous la forme d'un transformateur (37) ou d'une résistance de mesure de courant (35) ou d'un optocoupleur (32) ou d'un moyen de pilotage de frein (30).

5. Appareil électrique selon au moins l'une des revendications précédentes, **caractérisé en ce que** l'appareil électrique présente un dissipateur thermique,
le dissipateur thermique étant relié de manière thermoconductrice au premier module de puissance (5),
le dissipateur thermique étant relié de manière thermoconductrice au deuxième module de puissance (1),
le dissipateur thermique s'étendant en particulier en parallèle au plan de carte de circuits imprimés de la carte de circuits imprimés (9) du premier module de puissance (5) au deuxième ensemble de surfaces de contact et étant disposé à distance du deuxième ensemble de surfaces de contact, en particulier de telle sorte que le deuxième module de puissance (1) est disposé entre le dissipateur thermique et la carte de circuits imprimés (9) .

6. Appareil électrique selon au moins l'une des revendications précédentes, **caractérisé en ce que** la carte de circuits imprimés (9) présente deux évidements (40), et le dissipateur thermique présente deux taraudages,
chaque module de puissance (1, 5) présentant un évidement,
un moyen de vissage étant amené à passer partiellement à travers l'un des évidements (40) dans la carte de circuits imprimés (9) et à travers l'évidement dans le module de puissance respectif (1, 5) et relié par vissage à l'un des taraudages,
respectivement l'un des évidements (40) étant disposé dans la carte de circuits imprimés (9) et respectivement l'un des taraudages étant disposé en alignement mutuel.

7. Appareil électrique selon au moins l'une des revendications précédentes, **caractérisé en ce qu'**une zone d'extrémité du câble (6, 7, 8) est introduite dans le dispositif d'interconnexion (2, 3, 4) et est reliée par brasage au dispositif d'interconnexion (2, 3, 4).

8. Appareil électrique selon au moins l'une des revendications précédentes, **caractérisé en ce que** le moyen de liaison (10, 14, 16) équipe l'autre carte de circuits imprimés (11),
l'autre carte de circuits imprimés (11) présentant en particulier un plan de carte de circuits imprimés, et le moyen de liaison (10, 14, 16) faisant saillie à partir de l'autre carte de circuits imprimés (11) perpendiculairement à la direction normale du plan de carte de circuits imprimés,
une autre zone d'extrémité du câble (6, 7, 8) étant en particulier enfichée sur le moyen de liaison (10, 14, 16) .

9. Appareil électrique selon au moins l'une des revendications 1 à 8, **caractérisé en ce que** le moyen de liaison (10, 14, 16) est réalisé sous la forme d'un dispositif d'interconnexion dans l'autre carte de circuits imprimés (11),
une autre zone d'extrémité du câble (6, 7, 8) étant en particulier introduite dans le moyen de liaison (10, 14, 16) et reliée par brasage au moyen de liaison (10, 14, 16).

10. Appareil électrique selon au moins l'une des revendications 1 à 9, **caractérisé en ce que** l'appareil électrique présente au moins une partie de boîtier (17),
la partie de boîtier (17) présentant un premier évidement pour une première pièce formant connecteur enfichable (13) et un deuxième évidement pour une deuxième pièce formant connecteur enfichable (12),
la première pièce formant connecteur enfichable (13) étant insérée dans le premier évidement,
la deuxième pièce formant connecteur enfichable (12) étant insérée dans le deuxième évidement,
la deuxième carte de circuits imprimés (11) étant en particulier reliée de manière amovible à la partie de boîtier (17).

11. Série d'appareils électriques, la série présentant au moins un appareil électrique selon au moins l'une des revendications précédentes.

12. Procédé de fabrication d'un appareil électrique qui présente une carte de circuits imprimés (9) qui présente
- des pistes conductives, et
- deux ensembles de surfaces de contact de même type et/ou identiques,
un premier ensemble de surfaces de contact pouvant être équipé d'un premier module de puissance (5),
un deuxième ensemble de surfaces de contact pouvant être équipé d'un deuxième module de puissance (1),
la carte de circuits imprimés (9) présentant des dispositifs d'interconnexion (2, 3, 4) qui sont reliés de manière électriquement conductrice à respectivement une surface de contact (41) du deuxième ensemble de surfaces de contact à l'aide de pistes conductives sur la carte de circuits imprimés (9), et
l'appareil électrique présentant d'abord une première partie de boîtier, la première partie de boîtier présentant un seul évidement pour une partie de connexion de moteur,
dans lequel, pour la fabrication de l'appareil électrique, le premier module de puissance (5) équipe le premier ensemble de surfaces de contact et est relié de manière électriquement conductrice à une première partie de connexion de moteur qui est insérée dans l'évidement de la première partie de boîtier, et les dispositifs d'interconnexion (2, 3, 4) étant reliés de manière électriquement non conductrice à une partie de connexion de moteur,
l'appareil électrique présentant ensuite une deuxième partie de boîtier (17), la deuxième partie de boîtier (17) présentant un premier évidement pour une première partie de connexion de moteur et un deuxième évidement pour une deuxième partie de connexion de moteur,
dans lequel, pour la fabrication de l'appareil électrique, le premier module de puissance (5) équipe le premier ensemble de surfaces de contact et est relié de manière électriquement conductrice à une première partie de connexion de moteur qui est insérée dans l'évidement de la première partie de boîtier,
et de plus, un deuxième module de puissance (1) équipe le deuxième ensemble de surfaces de contact qui est relié de manière électriquement conductrice à une deuxième partie de connexion de moteur qui est insérée dans le deuxième évidement de la. deuxième partie de boîtier (17) qui est installée à la place de la première partie de boîtier dans l'appareil électrique, la première partie de connexion de moteur étant insérée dans le premier évidement de la deuxième partie de boîtier (17), et une autre carte de circuits imprimés (11) présentant la deuxième partie de connexion de moteur, d'autres pistes conductives et moyens de liaison (10, 14, 16) étant prévue, et les dispositifs d'interconnexion (2, 3, 4) étant respectivement reliés de manière électriquement conductrice aux moyens de liaison (10, 14, 16) à l'aide d'un câble (6, 7, 8).
